(19) Europäisches Patentamt
European Patent Office
Office européen des brevets

(11) **EP 2 707 736 B1**

(12) **FASCICULE DE BREVET EUROPEEN**

(45) Date de publication et mention
de la délivrance du brevet:
**27.02.2019 Bulletin 2019/09**

(51) Int Cl.:
***G01R 31/36*** (2019.01)

(21) Numéro de dépôt: **12718693.0**

(22) Date de dépôt: **05.04.2012**

(86) Numéro de dépôt international:
**PCT/FR2012/050732**

(87) Numéro de publication internationale:
**WO 2012/156602 (22.11.2012 Gazette 2012/47)**

(54) **PROCÉDÉ DE MESURE DE LA RÉSISTANCE INTERNE D'UNE BATTERIE, ET CAPTEUR ET SYSTÈME DE GESTION DE BATTERIE ADAPTES**

VERFAHREN ZUR MESSUNG DES INNENWIDERSTANDES EINER BATTERIE UND ADAPTIERTES BATTERIEVERWALTUNGSSYSTEM UND SENSOR

METHOD FOR MEASURING THE INTERNAL RESISTANCE OF A BATTERY, AND ADAPTED BATTERY MANAGEMENT SYSTEM AND SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.05.2011 FR 1154166**

(43) Date de publication de la demande:
**19.03.2014 Bulletin 2014/12**

(73) Titulaire: **Valeo Equipements Electriques Moteur 94046 Créteil Cedex (FR)**

(72) Inventeur: **BENCHETRITE, Daniel
F-940000 Creteil (FR)**

(74) Mandataire: **Cardon, Nicolas et al
Valeo Systèmes de Contrôle Moteur
Immeuble Le Delta
14, avenue des Béguines
95800 Cergy St Christophe (FR)**

(56) Documents cités:
**EP-A2- 1 830 197          FR-A1- 2 897 945
US-A1- 2008 094 069    US-A1- 2008 224 709**

**Description**

La présente invention concerne de manière générale la mesure de la résistance interne d'une batterie de véhicule automobile. L'invention concerne également un capteur de mesure de batterie et un système de gestion de batterie adapté à la mise en oeuvre du procédé de l'invention.

La détermination de la résistance interne de la batterie est une information demandée fréquemment par les constructeurs aux équipementiers automobiles. En effet, compte-tenu de l'évolution des véhicules actuels vers davantage d'électrification, une bonne connaissance de l'état des batteries de stockage d'énergie électrique est nécessaire pour être en mesure de les gérer de la manière la plus optimale possible, par exemple, pour les protéger contre toute détérioration, prolonger leur durée de vie et les maintenir dans un état de charge suffisant. La résistance interne de la batterie est un paramètre requis par différents algorithmes dans les applications embarquées. Elle est utile, par exemple, pour estimer la chute de tension aux bornes de la batterie lors d'une phase de démarrage du moteur thermique ou encore en tant qu'indicateur sommaire de l'état de santé de la batterie.

Il est connu dans la technique antérieure de mesurer la résistance interne d'une batterie par un essai de décharge. La résistance interne est alors obtenue par calcul du rapport $\Delta U/\Delta I$ entre un delta sur la tension aux bornes de la batterie, $\Delta U$, et un delta sur le courant traversant la batterie $\Delta I$.

Dans le document FR 2897945 A1 une valeur d'une résistance interne d'une batterie est calculée sur la base d'une pluralité des paires de données de courant et de tension. La valeur de la résistance interne est corrigée en utilisant une différence de tension en circuit ouvert.

On notera ici, pour toute la description qui suit, qu'un signe positif est affecté à un courant de charge de la batterie et un signe négatif est affecté à un courant de décharge de la batterie.

Selon les méthodes de mesure proposées dans la technique antérieure, l'essai de décharge varie de quelques secondes à quelques minutes. De telles durées s'avèrent prohibitives pour certaines applications et pénalisent une intégration aisée de ces méthodes de mesure dans les applications.

Il est donc souhaitable de proposer une nouvelle solution qui soit la moins intrusive possible pour les applications automobiles embarquées.

Selon un premier aspect, la présente invention concerne un procédé de mesure de la résistance interne d'une batterie équipant un véhicule automobile.

Conformément à l'invention, le procédé comporte les étapes de:

a) activer une fenêtre temporelle de mesure de la résistance interne de la batterie pendant une durée prédéterminée lorsqu'une décharge de la batterie supérieure à une décharge de niveau prédéterminée est détectée;

b) dans la fenêtre temporelle de mesure, collecter une pluralité d'échantillons de mesure de la tension aux bornes de la batterie et une pluralité d'échantillons de mesure du courant délivré par la batterie et rechercher dans ces pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

c) calculer la résistance interne de la batterie à partir du couple de mesure tension-courant obtenu à l'étape b) ci-dessus et d'un autre couple de valeurs tension-courant de la batterie mesuré avant l'activation de la fenêtre temporelle de mesure.

Selon une caractéristique particulière, la durée prédéterminée d'activation de la fenêtre temporelle de mesure est de l'ordre de 100 millisecondes.

Selon une autre caractéristique particulière, la décharge de la batterie provoquant l'activation de la fenêtre temporelle de mesure est détectée à partir du courant délivré par la batterie et/ou de la tension aux bornes de la batterie et/ou de la pente du courant ou de la tension.

Selon encore une autre caractéristique particulière, dans la fenêtre temporelle de mesure, la pluralité d'échantillons de mesure de la tension aux bornes de la batterie et la pluralité d'échantillons de mesure du courant délivré par la batterie sont obtenues chacune par un échantillonnage à une fréquence rapide de l'ordre de 1 khz.

Selon encore une autre caractéristique particulière, hors de la fenêtre temporelle de mesure, la mesure de la tension et la mesure du courant de la batterie sont effectuées chacune avec une fréquence d'échantillonnage lente de l'ordre de 5 hz.

Selon un mode de réalisation particulier, les étapes a) à c) du procédé selon l'invention ne sont mises en oeuvre qu'après une phase de repos de la batterie pendant laquelle son état de charge est demeuré stable, la phase de repos ayant une durée au moins égale à une durée prédéterminée.

Selon un autre aspect, l'invention concerne également un capteur de mesure de batterie pour une mise en oeuvre du procédé brièvement décrit ci-dessus.

Selon une première forme de réalisation du capteur selon l'invention, celui-ci comprend :

des moyens pour activer une fenêtre temporelle de mesure de la résistance interne de la batterie pendant une durée prédéterminée lorsqu'une décharge de la batterie supérieure à une décharge de niveau prédéterminée est détectée;

des moyens, activés dans la fenêtre temporelle de mesure, pour collecter une pluralité d'échantillons de mesure de la tension aux bornes de la batterie et une pluralité d'échantillons de mesure du courant délivré par la batterie et rechercher dans ces pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

des moyens pour transmettre ce couple de mesure tension-courant à un système de gestion de batterie ayant à charge un calcul de la résistance interne de la batterie.

Selon une seconde forme de réalisation du capteur selon l'invention, celui-ci comprend:

des moyens pour activer une fenêtre temporelle de mesure de la résistance interne de la batterie pendant une durée prédéterminée lorsqu'une décharge de la batterie supérieure à une décharge de niveau prédéterminée est détectée;

des moyens, activés dans la fenêtre temporelle de mesure, pour collecter une pluralité d'échantillons de mesure de la tension aux bornes de la batterie et une pluralité d'échantillons de mesure du courant délivré par la batterie et rechercher dans ces pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

des moyens pour calculer la résistance interne de la batterie à partir de ce couple de mesure tension-courant fourni par lesdits moyens pour collecter et rechercher et d'un autre couple de valeurs tension-courant de la batterie mesuré avant l'activation de la fenêtre temporelle de mesure.

Selon d'autres aspects, l'invention concerne aussi un système de gestion de batterie pour véhicule automobile comportant des moyens adaptés pour une mise en oeuvre du procédé brièvement décrit ci-dessus.

L'invention est maintenant décrite au travers de différents exemples de réalisation, en référence aux dessins ci-annexés. Il est à noter que ces dessins n'ont d'autre but que d'illustrer le texte de la description et ne constituent en aucune sorte une limitation de la portée de l'invention.

La Fig.1 est un bloc-diagramme d'une architecture de véhicule, représentée partiellement, montrant une unité de batterie d'alimentation dans laquelle est intégrée une forme de réalisation de l'invention; et

La Fig.2 montre un exemple de courbes de tension et de courant relatives à la batterie lors d'un démarrage d'un moteur thermique du véhicule.

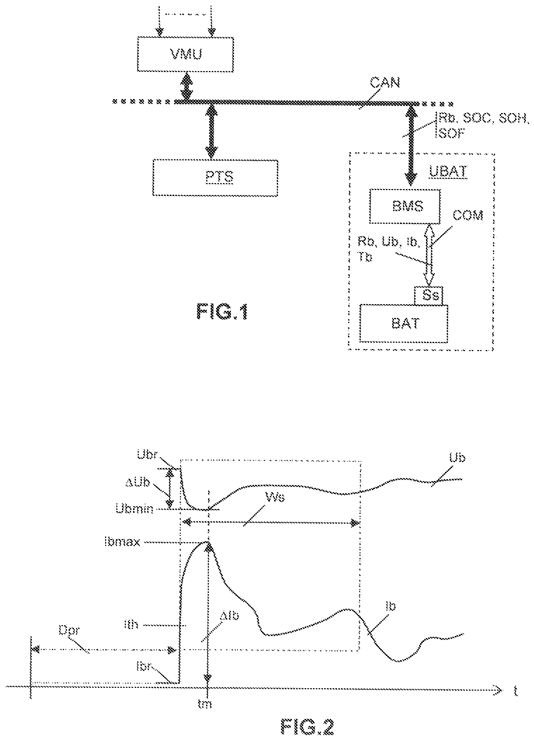

En référence à la Fig.1, il est décrit ci-après de manière simplifiée une unité de batterie d'alimentation UBAT intégrée dans un véhicule automobile qui peut être de type classique, c'est-à-dire à moteur thermique, ou bien de type hybride.

L'unité UBAT est associée à un système de propulsion PTS qui la sollicite essentiellement à des fins de traction du véhicule ou de démarrage du moteur thermique.

L'unité de batterie d'alimentation UBAT comporte essentiellement une batterie BAT équipée d'un capteur de mesure de batterie Ss et un système de gestion de batterie BMS.

Le système de gestion de batterie BMS est relié, par exemple à travers un bus de communication CAN, à un système de gestion de véhicule VMU qui contrôle le fonctionnement général du véhicule et à un système de gestion de moteur (non représenté) du système de propulsion PTS. Ces systèmes de gestion de batterie, de véhicule et de moteur sont bâtis chacun autour d'une unité électronique de commande dédiée (non représentée) et peuvent échanger des informations entre eux à travers le bus CAN.

Dans l'unité de batterie d'alimentation UBAT, le capteur de mesure de batterie Ss mesure la tension Ub aux bornes de la batterie BAT et le courant Ib qui la traverse. Dans cette forme de réalisation particulière, le capteur Ss mesure la température interne Tb de la batterie. Des échantillons de mesure pour Ub, Ib et Tb sont prélevés et numérisés par le capteur Ss qui les transmet ensuite au système de gestion de batterie BMS à travers une liaison de communication COM.

Dans cette forme de réalisation de la Fig.1, la résistance interne Rb de la batterie BAT est calculée par des moyens de traitement numérique du système BMS à partir des échantillons de mesure de Ub et Ib fournis par le capteur Ss.

Selon une autre forme de réalisation, avec un capteur Ss comprenant des capacités de traitement numérique disponibles, la résistance Rb pourra être calculée dans le capteur Ss à partir des échantillons de mesure de Ub et Ib et transmise au système BMS avec ces mêmes échantillons et les échantillons de mesure de Tb.

Le système BMS traite le flux de données en provenance du capteur Ss à l'aide de modules logiciels résidents. Après traitement de ces données, le système BMS délivre sur le bus de communication CAN, à l'intention des applications embarquées dans le véhicule, un ou plusieurs indicateurs représentatifs de l'état de la batterie BAT tels que la valeur de résistance interne Rb et les valeurs des indicateurs connus SOC, SOH et SOF pour respectivement « State Of Charge », « State Of Health » et « State Of Function » en terminologie anglaise.

Bien entendu, la forme de réalisation décrite brièvement ci-dessus n'est qu'un exemple de réalisation parmi de nombreuses configurations dans lesquelles l'invention peut être mise en oeuvre. Selon les applications embarquées dans les véhicules, différentes formes de réalisation et implantations des composants fonctionnels sont possibles. Ainsi, par exemple, la fonction BMS pourra être hébergée dans l'unité électronique d'un autre système de gestion et ne pas être supportée par une unité électronique dédiée.

Le procédé de mesure de la résistance interne d'une batterie selon l'invention va maintenant être décrit en détail en référence plus particulièrement à la Fig.2.

Dans cette forme de réalisation décrite en référence à la Fig.2, la mesure de la résistance interne Rb est effectuée après une phase de repos de la batterie ayant durée prédéterminée Dpr. On notera cependant que la nécessité de cette phase de repos dépendra des applications et que certains modes de réalisation du procédé selon l'invention ne comportent pas de phase de repos pour la batterie.

Dans la présente forme de réalisation, la durée de repos Dpr de la batterie dépendra du type de la batterie. Pour une batterie au plomb par exemple, Dpr aura typiquement au moins une durée de l'ordre de 2 heures.

Les phases de repos avant la mesure de la résistance interne Rb sont typiquement des phases de stationnement du véhicule pendant lesquelles le courant de décharge consommé sur la batterie est relativement faible.

Pour réaliser la mesure de la résistance Rb, le capteur Ss doit être capable d'effectuer à une fréquence rapide des mesures simultanées de la tension et du courant, Ub et Ib, de la batterie. Typiquement, une fréquence d'échantillonnage Fe de l'ordre de 1 kHz pourra être utilisée ici pour ces mesures.

On notera cependant que cette fréquence d'échantillonnage rapide Fe pour le fonctionnement du capteur Ss n'est requise que lors de la mesure de la résistance interne Rb conformément à l'invention. En dehors de ces phases de mesure, le capteur Ss pourra échantillonner à fréquence lente (de l'ordre de 5 Hz) pour la fourniture de ses mesures Ub, Ib et Ib au système de gestion de batterie BMS. Dans un mode de réalisation particulier de l'invention, le capteur Ss pourra fonctionner à fréquence lente lorsque le courant Ib charge la batterie BAT (c'est-à-dire, lorsque la batterie est rechargée par l'alternateur du véhicule), le fonctionnement à fréquence rapide Fe intervenant dès lors que le courant Ib devient un courant de décharge de la batterie BAT.

En référence à la Fig.2, lorsque le système BMS détecte, après une durée de repos Dpr, un courant de décharge important Ib fourni par la batterie BAT, une fenêtre Ws pour une mesure à fréquence rapide Fe est activée. Cette fenêtre Ws aura une durée typiquement de l'ordre de 100 ms. La fenêtre Ws est activée ici lorsque le courant de décharge Ib devient, en valeur absolue, supérieur à un seuil prédéterminé Ith. Selon une variante, la condition d'une pente du courant Ib supérieure à une valeur de seuil prédéterminée sera également nécessaire pour l'activation de la fenêtre de mesure Ws. Selon encore une autre variante, l'activation de la fenêtre Ws sera commandée à partir d'une détection faite sur la tension Ub et non sur le courant Ib. Pendant toute la durée de la fenêtre Ws, le courant Ib et la tension Ub sont mesurés par échantillonnage à la fréquence rapide Fe. Un processus de traitement hébergé dans le système BMS traite le flux de données numériques transmis par le capteur Ss et en extrait des données de mesure correspondant aux mesures des courant et tension Ib et Ub. Le processus de traitement effectue une recherche dans ces données de mesure extraites de manière à identifier un couple tension-courant (Ubmin, Ibmax) à un temps tm de la fenêtre de mesure Ws. Ubmin est la valeur de la tension Ub correspondant à une chute de tension maximale de celle-ci dans la fenêtre Ws. A Ubmin est associé le courant Ibmax qui correspond à une intensité maximale du courant Ib dans la fenêtre Ws.

Une fois déterminé le couple (Ubmin, Ibmax), la résistance interne Rb est donnée par la formule ci-dessous:

```
Rb = ΔUb/ΔIb = Valeur Absolue[(Ubr-Ubmin)/(Ibmax-
Ibr)],
```

avec Ubr et Ibr qui sont les valeurs des tension et courant, Ub et Ib, de la batterie peu de temps avant le déclenchement de la fenêtre de mesure Ws.

Bien entendu, différentes variantes de réalisation de l'invention sont à la portée de l'homme du métier instruit par les enseignements qui lui sont apportés ici. Ainsi, dans le cas où le calcul de la résistance interne de la batterie est effectué dans le capteur Ss, soulageant ainsi le système BMS d'une charge de calcul, la liaison de communication COM pourra avoir un débit plus faible du fait qu'il deviendra alors inutile de transmettre Ub et Ib à fréquence rapide pendant la durée de la fenêtre de mesure.

**Revendications**

1. Procédé de mesure de la résistance interne d'une batterie équipant un véhicule automobile, **caractérisé en ce qu'**il comporte les étapes de :

   a) activer une fenêtre temporelle (Ws) de mesure de la résistance interne (Rb) de la batterie pendant une durée prédéterminée lorsqu'une décharge (Ib) de la batterie supérieure à une décharge de niveau prédéterminée (Ith) est détectée;

   b) dans ladite fenêtre temporelle (Ws), collecter une pluralité d'échantillons de mesure de la tension (Ub) aux bornes de la batterie et une pluralité d'échantillons de mesure du courant (Ib) délivré par la batterie et rechercher dans ces pluralités d'échantillons de mesure un couple de mesure tension-courant (Ubmin, Ibmax) correspondant, sensiblement à un même instant de mesure (tm), à un échantillon de mesure de tension de valeur minimale et un échantillon de mesure de courant de valeur maximale, ces valeurs minimale et maximale étant considérées en valeur absolue; et

   c) calculer la résistance interne (Rb) de la batterie à partir du couple de mesure tension-courant (Ubmin, Ibmax) obtenu à l'étape b) ci-dessus et d'un autre couple de valeurs tension-courant (Ubr, Ibr) de la batterie mesuré avant l'activation de la fenêtre temporelle de mesure (Ws), en appliquant l'égalité : Rb = Valeur Absolue[(Ubr-Ubmin)/( Ibmax-Ibr)], Rb étant la résistance interne, Ubmin et Ibmax étant ledit couple de mesure tension-courant obtenu à l'étape b) et Ubr et Ibr étant ledit autre couple de valeurs tension-courant.

2. Procédé selon la revendication 1, **caractérisé en ce que** la durée prédéterminée d'activation de la fenêtre temporelle de mesure (Ws) est de l'ordre de 100 millisecondes.

3. Procédé selon la revendication 1 ou 2, **caractérisé en ce que** la décharge de la batterie provoquant l'activation de la fenêtre temporelle de mesure (Ws) est détectée à partir du courant (Ib) délivré par la batterie et/ou de la tension (Ub) aux bornes de la batterie et/ou de la pente dudit courant (Ib) ou de ladite tension (Ub).

4. Procédé selon l'une quelconque des revendications 1 à 3, **caractérisé en ce que** dans ladite fenêtre temporelle (Ws), ladite pluralité d'échantillons de mesure de la tension aux bornes de la batterie et ladite pluralité d'échantillons de mesure du courant délivré par la batterie sont obtenues chacune par un échantillonnage à une fréquence rapide de l'ordre de 1 khz.

5. Procédé selon l'une quelconque des revendications 1 à 4, **caractérisé en ce que** hors de ladite fenêtre temporelle (Ws), la mesure de la tension et la mesure du courant de la batterie sont effectuées chacune avec une fréquence d'échantillonnage lente de l'ordre de 5 hz.

6. Capteur de mesure de batterie adapté pour une mise en oeuvre du procédé selon l'une quelconque des revendications 1 à 5, **caractérisé en ce qu'**il comprend :

   des moyens pour activer une fenêtre temporelle (Ws) de mesure de la résistance interne de la batterie pendant une durée prédéterminée lorsqu'une décharge de la batterie supérieure à une décharge de niveau prédéterminée est détectée;

   des moyens, activés dans ladite fenêtre temporelle (Ws), pour collecter une pluralité d'échantillons de mesure de la tension aux bornes de la batterie et une pluralité d'échantillons de mesure du courant délivré par la batterie et rechercher dans lesdites pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

   des moyens pour transmettre ledit couple de mesure tension-courant (Ubmin, Ibmax) à un système de gestion de batterie (BMS) ayant à charge un calcul de ladite résistance interne (Rb).

7. Capteur de mesure de batterie adapté pour une mise en oeuvre du procédé selon l'une quelconque des revendications 1 à 5, **caractérisé en ce qu'**il comprend :

   des moyens pour activer une fenêtre temporelle (Ws) de mesure de la résistance interne de la batterie pendant une durée prédéterminée lorsqu'une décharge de la batterie supérieure à une décharge de niveau prédéterminée est détectée;

   des moyens, activés dans ladite fenêtre temporelle (Ws), pour collecter une pluralité d'échantillons de mesure de la tension aux bornes de la batterie et une pluralité d'échantillons de mesure du courant délivré par la batterie et rechercher dans lesdites pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

des moyens pour calculer la résistance interne de la batterie à partir dudit couple de mesure tension-courant fourni par lesdits moyens pour collecter et rechercher et d'un autre couple de valeurs tension-courant de la batterie mesuré avant l'activation de la fenêtre temporelle de mesure (Ws).

8. Système de gestion de batterie pour véhicule automobile, **caractérisé en ce qu'**il comprend des moyens adaptés pour une mise en oeuvre du procédé selon l'une quelconque des revendications 1 à 5.

9. Combinaison d'un système de gestion de batterie et d'un capteur de mesure de batterie, **caractérisée en ce que** le capteur est un capteur selon la revendication 6 et le système de gestion de batterie comprend des moyens de calcul de la résistance interne (Rb) de la batterie à partir d'un couple de mesure tension-courant (Ubmin, Ibmax) de la batterie (BAT) fourni par le capteur (Ss).

10. Combinaison d'un système de gestion de batterie et d'un capteur de mesure de batterie, **caractérisée en ce que** le capteur est un capteur selon la revendication 7.

**Patentansprüche**

1. Verfahren zur Messung des Innenwiderstands einer Batterie, mit der ein Kraftfahrzeug ausgestattet ist, **dadurch gekennzeichnet, dass** es die folgenden Schritte umfasst:

a) Aktivieren eines Zeitfensters (Ws) für die Messung des Innenwiderstands (Rb) der Batterie während eines vorbestimmten Zeitraums, wenn eine Entladung (Ib) der Batterie detektiert wird, die höher als ein vorbestimmter Entladungspegel (Ith) ist;

b) in dem Zeitfenster (Ws) Sammeln von mehreren Messproben der Spannung (Ub) an den Klemmen der Batterie und von mehreren Messproben des von der Batterie gelieferten Stroms (Ib) und Suchen in diesen mehreren Messproben nach einem Messpaar Spannung-Strom (Ubmin, Ibmax), das im Wesentlichen zu einem gleichen Messzeitpunkt (tm) einer Spannungsmessprobe mit minimalem Wert und einer Strommessprobe mit maximalem Wert entspricht, wobei diese minimalen und maximalen Werte als Absolutwerte betrachtet werden; und

c) Berechnen des Innenwiderstands (Rb) der Batterie ausgehend von dem in dem obigen Schritt b) erhaltenen Messpaar Spannung-Strom (Ubmin, Ibmax) und einem anderen Wertepaar Spannung-Strom (Ubr, Ibr) der Batterie, das vor der Aktivierung des Zeitfensters für die Messung (Ws) gemessen wurde, indem die folgende Gleichung angewendet wird: $Rb = \text{Absolutwert}[(Ubr-Ubmin)/(Ibmax-Ibr)]$, wobei Rb der Innenwiderstand ist, Ubmin und Ibmax das im Schritt b) erhaltene Messpaar Spannung-Strom sind und Ubr und Ibr das andere Wertepaar Spannung-Strom sind.

2. Verfahren nach Anspruch 1, **dadurch gekennzeichnet, dass** der vorbestimmte Zeitraum der Aktivierung des Zeitfensters für die Messung (Ws) in der Größenordnung von 100 Millisekunden liegt.

3. Verfahren nach Anspruch 1 oder 2, **dadurch gekennzeichnet, dass** die Entladung der Batterie, welche die Aktivierung des Zeitfensters für die Messung (Ws) hervorruft, auf Basis des Stroms (Ib), der durch die Batterie geliefert wird, und/oder der Spannung (Ub) an den Klemmen der Batterie und/oder der Steigung des Stroms (Ib) oder der Spannung (Ub) detektiert wird.

4. Verfahren nach einem der Ansprüche 1 bis 3, **dadurch gekennzeichnet, dass** in dem Zeitfenster (Ws) die mehreren Messproben der Spannung an den Klemmen der Batterie und die mehreren Messproben des von der Batterie gelieferten Stroms jeweils durch eine Abtastung mit einer schnellen Frequenz in der Größenordnung von 1 kHz erhalten werden.

5. Verfahren nach einem der Ansprüche 1 bis 4, **dadurch gekennzeichnet, dass** außerhalb dieses Zeitfensters (Ws) die Messung der Spannung und die Messung des Stroms der Batterie jeweils mit einer langsamen Abtastfrequenz in der Größenordnung von 5 Hz erfolgen.

**6.** Batteriemesssensor, der für eine Ausführung des Verfahrens nach einem der Ansprüche 1 bis 5 eingerichtet ist, **dadurch gekennzeichnet, dass** er umfasst:

Mittel zum Aktivieren eines Zeitfensters (Ws) für die Messung des Innenwiderstands der Batterie während eines vorbestimmten Zeitraums, wenn eine Entladung der Batterie detektiert wird, die höher als ein vorbestimmter Entladungspegel ist;

in dem Zeitfenster (Ws) aktivierte Mittel zum Sammeln von mehreren Messproben der Spannung an den Klemmen der Batterie und von mehreren Messproben des von der Batterie gelieferten Stroms und zum Suchen in diesen mehreren Messproben nach einem Messpaar Spannung-Strom, das im Wesentlichen zu einem gleichen Messzeitpunkt einer Spannungsmessprobe mit minimalem Wert und einer Strommessprobe mit maximalem Wert entspricht, wobei diese minimalen und maximalen Werte als Absolutwerte betrachtet werden; und

Mittel zum Senden des Messpaars Spannung-Strom (Ubmin, Ibmax) an ein Batterieverwaltungssystem (BMS), das eine Berechnung des Innenwiderstands (Rb) zur Aufgabe hat.

**7.** Batteriemesssensor, der für eine Ausführung des Verfahrens nach einem der Ansprüche 1 bis 5 eingerichtet ist, **dadurch gekennzeichnet, dass** er umfasst:

Mittel zum Aktivieren eines Zeitfensters (Ws) für die Messung des Innenwiderstands der Batterie während eines vorbestimmten Zeitraums, wenn eine Entladung der Batterie detektiert wird, die höher als ein vorbestimmter Entladungspegel ist;

in dem Zeitfenster (Ws) aktivierte Mittel zum Sammeln von mehreren Messproben der Spannung an den Klemmen der Batterie und von mehreren Messproben des von der Batterie gelieferten Stroms und zum Suchen in diesen mehreren Messproben nach einem Messpaar Spannung-Strom, das im Wesentlichen zu einem gleichen Messzeitpunkt einer Spannungsmessprobe mit minimalem Wert und einer Strommessprobe mit maximalem Wert entspricht, wobei diese minimalen und maximalen Werte als Absolutwerte betrachtet werden; und

Mittel zum Berechnen des Innenwiderstands der Batterie auf Basis des Messpaars Spannung-Strom, das von den Mitteln zum Sammeln und Suchen geliefert wird, und eines anderen Wertepaars Spannung-Strom der Batterie, das vor der Aktivierung des Zeitfensters für die Messung (Ws) gemessen wird.

**8.** System zur Verwaltung einer Batterie für ein Kraftfahrzeug, **dadurch gekennzeichnet, dass** es Mittel umfasst, die für eine Ausführung des Verfahrens nach einem der Ansprüche 1 bis 5 eingerichtet sind.

**9.** Kombination aus einem Batterieverwaltungssystem und einem Batteriemesssensor, **dadurch gekennzeichnet, dass** der Sensor ein Sensor nach Anspruch 6 ist und das Batterieverwaltungssystem Mittel zum Berechnen des Innenwiderstands (Rb) der Batterie auf Basis eines Messpaars Spannung-Strom (Ubmin, Ibmax) der Batterie (BAT) umfasst, das von dem Sensor (Ss) bereitgestellt wird.

**10.** Kombination aus einem Batterieverwaltungssystem und einem Batteriemesssensor, **dadurch gekennzeichnet, dass** der Sensor ein Sensor nach Anspruch 7 ist.

**Claims**

**1.** Method for measuring the internal resistance of a battery fitted to a motor vehicle, **characterized in that** it includes the steps of:

a) activating a time window (Ws) for measuring the internal resistance (Rb) of the battery over a predetermined duration when it is detected that the battery is being discharged (Ib) beyond a predetermined discharge level (Ith);

b) in said time window (Ws), collecting a plurality of measurement samples of the voltage (Ub) across the terminals of the battery and a plurality of measurement samples of the current (Ib) delivered by the battery and searching through these pluralities of measurement samples for a voltage-current measurement pair (Ubmin, Ibmax) corresponding, substantially at one and the same measurement time (tm), to a minimum-value voltage measurement sample and to a maximum-value current measurement sample, these minimum and maximum values being considered in terms of absolute value; and

c) calculating the internal resistance (Rb) of the battery on the basis of the voltage-current measurement pair (Ubmin, Ibmax) obtained in step b) above and of another pair of voltage-current values (Ubr, Ibr) of the battery measured before the activation of the measurement time window (Ws), by applying the equality: Rb = Absolute Value[(Ubr-Ubmin)/(Ibmax-Ibr)], Rb being the internal resistance, Ubmin and Ibmax being said voltage-current measurement pair obtained in step b) and Ubr and Ibr being said other pair of voltage-current values.

2. Method according to Claim 1, **characterized in that** the predetermined duration of activation of the measurement time window (Ws) is of the order of 100 milliseconds.

3. Method according to Claim 1 or 2, **characterized in that** the discharging of the battery causing the activation of the measurement time window (Ws) is detected on the basis of the current (Ib) delivered by the battery and/or of the voltage (Ub) across the terminals of the battery and/or of the slope of said current (Ib) or of said voltage (Ub).

4. Method according to any one of Claims 1 to 3, **characterized in that** in said time window (Ws), said plurality of measurement samples of the voltage across the terminals of the battery and said plurality of measurement samples of the current delivered by the battery are each obtained by sampling at a high frequency of the order of 1 kHz.

5. Method according to any one of Claims 1 to 4, **characterized in that** outside of said time window (Ws), the voltage and the current of the battery are each measured with a low sampling frequency of the order of 5 Hz.

6. Battery measurement sensor suitable for implementing the method according to any one of Claims 1 to 5, **characterized in that** it comprises:

means for activating a time window (Ws) for measuring the internal resistance of the battery over a predetermined duration when it is detected that the battery is being discharged beyond a predetermined discharge level; means, activated in said time window (Ws), for collecting a plurality of measurement samples of the voltage across the terminals of the battery and a plurality of measurement samples of the current delivered by the battery and searching through said pluralities of measurement samples for a voltage-current measurement pair corresponding, substantially at one and the same measurement time, to a minimum-value voltage measurement sample and to a maximum-value current measurement sample, these minimum and maximum values being considered in terms of absolute value; and means for transmitting said voltage-current measurement pair (Ubmin, Ibmax) to a battery management system (BMS) responsible for calculating said internal resistance (Rb).

7. Battery measurement sensor suitable for implementing the method according to any one of Claims 1 to 5, **characterized in that** it comprises:

means for activating a time window (Ws) for measuring the internal resistance of the battery over a predetermined duration when it is detected that the battery is being discharged beyond a predetermined discharge level; means, activated in said time window (Ws), for collecting a plurality of measurement samples of the voltage across the terminals of the battery and a plurality of measurement samples of the current delivered by the battery and searching through said pluralities of measurement samples for a voltage-current measurement pair corresponding, substantially at one and the same measurement time, to a minimum-value voltage measurement sample and to a maximum-value current measurement sample, these minimum and maximum values being considered in terms of absolute value; and means for calculating the internal resistance of the battery on the basis of said voltage-current measurement pair delivered by said collecting and searching means and of another pair of voltage-current values of the battery measured before the activation of the measurement time window (Ws).

8. Battery management system for a motor vehicle, **characterized in that** it comprises means suitable for implementing the method according to any one of Claims 1 to 5.

9. Combination of a battery management system and of a battery measurement sensor, **characterized in that** the sensor is a sensor according to Claim 6 and the battery management system comprises means for calculating the internal resistance (Rb) of the battery on the basis of a voltage-current measurement pair (Ubmin, Ibmax) of the battery (BAT) delivered by the sensor (Ss).

10. Combination of a battery management system and of a battery measurement sensor, **characterized in that** the sensor is a sensor according to Claim 7.

FIG.1

FIG.2

**EP 2 707 736 B1**

**RÉFÉRENCES CITÉES DANS LA DESCRIPTION**

**Documents brevets cités dans la description**

- FR 2897945 A1